# EUROPEAN PATENT APPLICATION

(11) **EP 4 054 085 A1**
(43) Date of publication of application: **07.09.2022**
(21) Application number: 21160778.3
(22) Date of filing: 04.03.2021
(51) Int. Cl.: H04B 5/00, H02J 50/90

(54) **A POSITIONING SYSTEM AND METHOD FOR TESTING OF WIRELESS POWER EQUIPMENT**

(71) Applicant: ElectDis AB, 211 21 Malmö (SE)
(72) Inventor: Swaans, Laurens, 212 32 Malmö (SE); Tillerkvist, Tony, 291 66 Kristianstad (SE)
(74) Representative: Ström & Gulliksson AB

(57) **Abstract**

A positioning system (100) for testing of wireless power equipment in the form of a wireless power transmitter device (20) and/or a wireless power receiver device (10) is provided. The positioning system (100) comprising a main body (110) comprises a first portion (112) arranged to receive at least one wireless power transmitter device (20), a second portion (118) comprising a movable attachment member (130) arranged to receive one wireless power receiver device (10), wherein the attachment member (130) comprises rotating means (136) configured to provide a rotation of the movable attachment member (130), and at least one position adjusting means (120) arranged to control the rotation of the attachment member (130) between a first end position and a second end position.

## Description

### Technical Field

The present invention generally relates to the field of wireless power transfer, and more specifically to testing of wireless power equipment using a positioning system. Even more specifically, the present invention relates to a positioning system for testing of wireless power equipment in the form of a wireless power transmitter device and/or a wireless power receiver device. The present invention also relates to an associated method.

### Background

Wireless power transfer is expected to become increasingly popular, for instance for wireless battery charging of mobile devices such as, for instance, mobile terminals, tablet computers, laptop computers, cameras, audio players, rechargeable toothbrushes, smart watches, wireless headsets, as well as various other consumer products and appliances.

The Wireless Power Consortium has developed a wireless power transfer standard known as Qi. Other known wireless power transfer approaches include Alliance for Wireless Power, and Power Matters Alliance.

The wireless power transfer standard known as Qi by the Wireless Power Consortium is one wireless power transfer manner. Operation of devices that comply with Qi relies on magnetic induction between planar coils. Two kinds of devices are involved, namely devices that provide wireless power (referred to as base stations or wireless power transmitter devices), and devices that consume wireless power (referred to as mobile devices). Power transfer takes place from a base station to a mobile device. For this purpose, a base station contains a subsystem (a power transmitter) that comprises a primary coil, whereas a mobile device contains a subsystem (a power receiver) that comprises a secondary coil. In operation, the primary coil and the secondary coil will constitute the two halves of a coreless resonant transformer. Typically, a base station has a flat surface, on top of which a user can place one or more mobile devices so as to enjoy wireless battery charging or operational power supply for the mobile device(s) placed on the base station.

There is a need among different interest groups to test, measure or evaluate the behavior of the base station and/or the power receiver (mobile device) when performing wireless power transfer. Such interest groups may for instance involve any of the following: developers, manufacturers or suppliers of mobile devices; developers, manufacturers or suppliers of wireless power transmitter devices; test or compliance entities in the field of wireless power transfer; and test or compliance entities in the field of consumer product safety.

### Summary

It is an object of the invention to offer improvements in the technical field of testing, verifying, evaluating, researching and designing (henceforth referred to as 'testing') wireless power equipment.

In a first aspect, a positioning system for testing of wireless power equipment in the form of a wireless power transmitter device and/or a wireless power receiver device is provided. The positioning system comprises a main body comprising a first portion arranged to receive at least one wireless power transmitter device, a second portion comprising a movable attachment member arranged to receive one wireless power receiver device, wherein the attachment member comprises rotating means configured to provide a rotation of the movable attachment member, and at least one position adjusting means arranged to control the rotation of the attachment member between a first end position and a second end position.

In one embodiment, the rotating means comprises restriction means configured to restrict the rotation of the attachment member.

The first portion may be arranged to be movable along the y-axis, and wherein the second may be arranged to be movable along the x-axis. The movable attachment member may be arranged to be rotatable around its axis.

In one embodiment, in the first end position the attachment member is arranged such that the wireless power receiver device is arranged at distance from the wireless power transmitter device.

In one embodiment, in the second end position the attachment member is arranged such that the wireless power receiver device is arranged adjacent to the wireless power transmitter device. The wireless power receiver device may be arranged in contact with the wireless power transmitter device in the second end position.

In one embodiment, the at least one wireless power transmitter device is arranged on a holding means, wherein the holding means is configured to be adjustable between a flat and an inclined position.

The positioning system may be in operative communication with a processing unit. The processing unit may be configured to provide feedback to the user of the positioning system relating to re-positioning of the first portion, the second portion and/or the attachment member.

In one embodiment, the processing unit is configured to provide feedback to the positioning system and to instruct re-positioning of the first movable portion, the second movable portion and/or the attachment member. The feedback may be generated based on test data.

In a second aspect a method for positioning a wireless power transmitter device and/or a wireless power receiver device for testing of wireless power equipment is provided. The method comprises providing a first portion arranged to receive at least one wireless power transmitter device, providing a second portion comprising a movable attachment member arranged to receive one wireless power receiver device, wherein the attachment member comprises rotating means configured to provide a rotation of the movable attachment member, and controlling the rotation of the attachment member between a first end position and a second end position.

### Brief Description of the Drawings

Objects, features and advantages of embodiments of the invention will appear from the following detailed description, reference being made to the accompanying drawings.
Fig. 1 is a schematic block diagram of a wireless power transmitter device for wireless power transfer to a wireless power receiver device.
Fig. 2 is an isometric view of a positioning system according to one embodiment being arranged in a first position.
Fig. 3 is an isometric view of a positioning system according to one embodiment being arranged in a second position.
Fig. 4 is an isometric view of a positioning system according to a second embodiment being arranged in a second position.
Fig. 5 is an isometric view of a positioning system according to a third embodiment being arranged in a first position.
Fig. 6 is an isometric view of a positioning system according to a third embodiment being arranged in a second position.
Fig. 7 is a schematic view of a wireless power receiver device according to one embodiment.
Fig. 8 is an isometric view of an attachment member in a positioning system according to one embodiment.
Figs. 9a-b are schematic top views of a part of a positioning system according to one embodiment.
Figs. 10a-b are schematic top views of a part of a positioning system according to different embodiments.
Figs. 11a-b are schematic views of a part of a positioning system according to different embodiments.
Fig. 12 is an illustrative view of a method according to one embodiment.

### Detailed Description

Embodiments of the invention will now be described with reference to the accompanying drawings. The invention may, however, be embodied in many different forms and should not be construed as limited to the embodiments set forth herein; rather, these embodiments are provided so that this disclosure will be thorough and complete, and will fully convey the scope of the invention to those skilled in the art. The terminology used in the detailed description of the particular embodiments illustrated in the accompanying drawings is not intended to be limiting of the invention. In the drawings, like numbers refer to like elements.

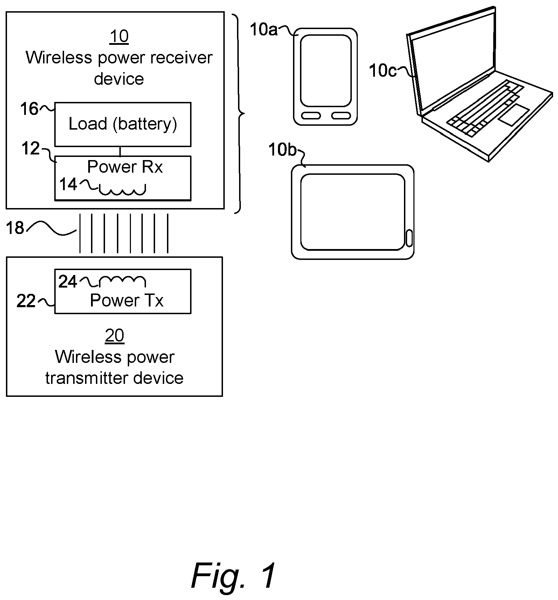

Fig. 1 illustrates a wireless power transmitter device 20 for wireless power transfer to a wireless power receiver device 10. The wireless power receiver device 10 may, for instance, be a mobile device like a mobile terminal (e.g. smartphone) 10a, tablet computer 10b, laptop computer 10c, camera, audio player, rechargeable toothbrush, wireless headset, or another kind of consumer, military or medical product or appliance.

The wireless power transfer will be described as being compliant with the Qi standard by the Wireless Power Consortium; hence, the wireless power transmitter device 20 is a base station in the Qi terminology. However, as already mentioned, the invention is generally applicable also to other wireless power transfer standards or approaches, including but not limited to the ones previously mentioned.

The wireless power transmitter device 20 comprises a wireless power transmitter 22 having at least one wireless power transmitter coil 24. Correspondingly, the wireless power receiver device 10 comprises a wireless power receiver 12 having a wireless power receiver coil 14. In operation, the wireless power transmitter device 20 will transfer power wirelessly to the wireless power receiver device 10 by way of magnetic induction 18 via the wireless power transmitter coil 24 and wireless power receiver coil 14.

The power received by the wireless power receiver coil 14 will drive a load 16 in the mobile device 10. Typically, the load 16 may be a rechargeable battery, such as a lithium ion battery; hence, the wireless power transmitter device 20 will act as a wireless power charger for the wireless power receiver device 10. In another scenario, the load 16 may be electronic circuitry in the mobile device, wherein the wireless power transmitter device 20 will act as a wireless power supply for the wireless power receiver device 10.

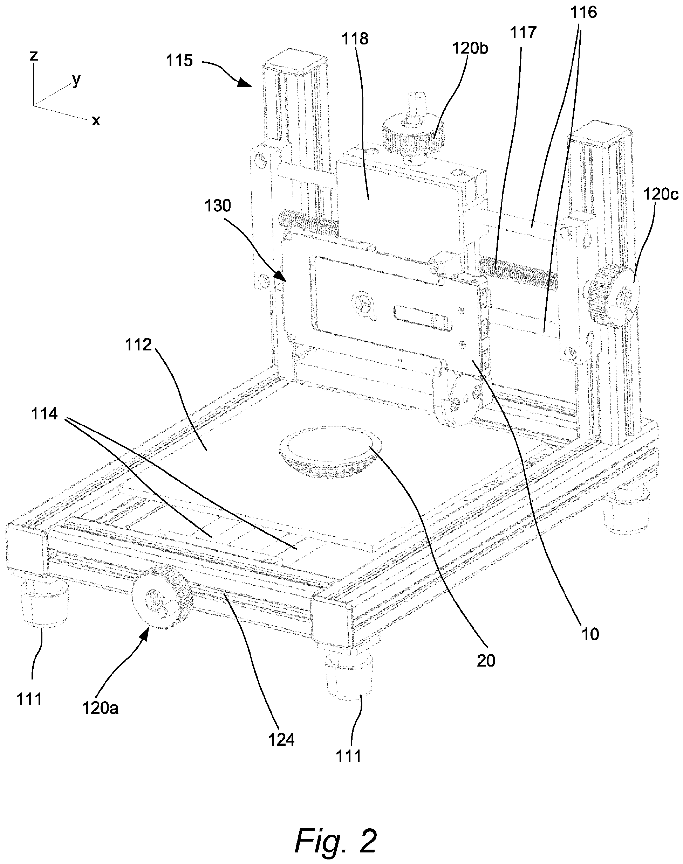

In order to test the wireless power equipment in a reproducible manner, a positioning system 100 is provided. The positioning system 100 is arranged for testing of wireless power equipment in the form of a wireless power transmitter device, such as device 20 in Fig. 1, and/or a wireless power receiver device, such as device 10 in Fig. 1. The positioning system 100 is arranged to provide accurate position readings in two or three dimensions when testing wireless power equipment. By altering the position of the wireless power transmitter device 20 and/or the position of the wireless power receiver device 10 with a high precision, important information of the behavior of the devices 10, 20 can be determined. The positioning system 100 will now be described more in detail with reference to Figs. 2-11.

As seen in Figs. 2-6, the positioning system 100 comprises a main body 110, comprising a first portion 112 and a second portion 118. In one embodiment, at least one wireless power transmitter device 20 is arrangeable at the first portion 112, and the at least one wireless power receiver device 10 is arrangeable at the second portion 118. In an alternative embodiment (not shown), at least one wireless power transmitter device 20 is arrangeable at the second portion 118, and the at least one wireless power receiver device 10 is arrangeable at the first portion 112.

In the embodiments shown in Figs. 2-6, the first portion 112 has an extension in the x-y-plane. The first portion 112 is preferably in the shape of a plate extending along the x-y-direction.

It is preferred if the first portion 112 is movable along at least one axis. In this way, the wireless power transmitter device 20 and the wireless power receiver device 10 are movably arranged in relation to each other.

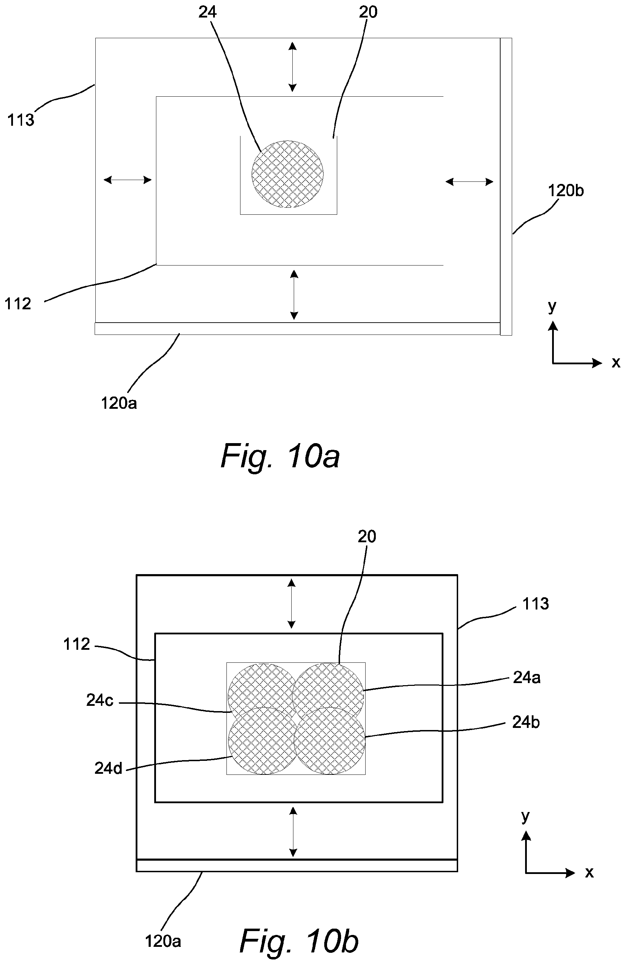

In one embodiment, the movement of the first portion 112 is in the horizontal plane. In Figs. 2-6, the horizontal plane is defined by the x- and y- axis. In the embodiment shown in Figs. 2-6, the movement of the first portion 112 is along the y-axis. However, it should be understood that the movement of the first portion 112 additionally or alternatively could be along the x-axis. This is shown and described more in detail with reference to Figs. 10a-b.

### The wireless power transmitter device

As previously described, the first portion 112 is preferably arranged with at least one wireless power transmitter device 20. The wireless power transmitter device 20 is preferably arranged in the center of the first portion 112, as shown in Fig. 2. However, as should be understood by a person skilled in the art the wireless power transmitter device 20 could be arranged on other parts of the first portion 112. The wireless power transmitter device 20 could be arranged on top of the surface of the first portion 112, as shown in Fig. 2, or being arranged in a recess (not shown) of the first portion 112.

In order to test different wireless power transmitter device 20, it is preferred if the wireless power transmitter device 20 is removably arranged on the first portion 112. The wireless power transmitter device 20 may for example be attached to the first portion 112 using an adhesive or other fastening means. In one embodiment the wireless power transmitter device 20 is attached to the first portion 112 using one or more clamps. Additionally or alternatively, the wireless power transmitter device 20 is attached to the first portion 112 using one or more straps.

In one embodiment, the wireless power transmitter device 20 is arranged on a holding means (not shown). The holding means can be adjusted between a flat and an inclined position, so as to alter the inclination of the wireless power transmitter device 20.

The wireless power transmitter device 20 is preferably identical or similar to the wireless power transmitter device 20 described in relation to Fig. 1. The wireless power transmitter device 20 may have one transmitter coil 24 or a plurality of transmitter coils. If the transmitter device 20 has a plurality of transmitter coils, these may be arranged in a spaced apart arrangement and/or in a partly overlapping manner. In one embodiment, a plurality of transmitter coils is arranged in a partly overlapping manner on the same, or mainly the same, horizontal axis so that the majority of the surface of the transmitter device 20 is arranged close to at least one transmitter coil.

In an alternative embodiment, four transmitter coils are arranged in a formation similar to a two times two matrix. In this embodiment, two of the transmitter coils are overlapping each other while some of the transmitter coils are arranged in a space apart arrangement from each other.

In yet one embodiment, a plurality of transmitter coils are arranged in a circular pattern by having a central transmitter coil that is arranged in the centre of the transmitter device 20 and a plurality of transmitter coils are arranged in a partly overlapping way around the central coil. In this configuration, the transmitter coils will act as if the coil was hexagonally shaped.

In one embodiment, as seen in Figs. 2-3, the wireless power transmitter device 20 has with a flat surface, hence a surface without any inclination. The wireless power transmitter device 20 may be arranged in a holding means, as previously described, or directly on the first portion 112. The surface of the wireless power transmitter device 20 resembles charging a wireless power receiver device 10 on a flat surface.

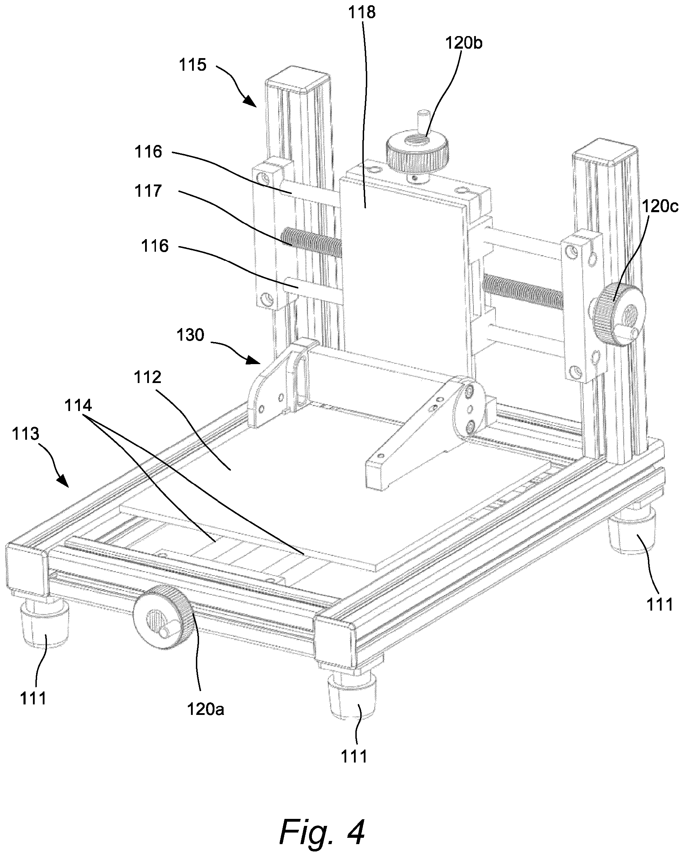

Fig. 4 shows an embodiment of the positioning system 100 where the wireless power transmitter device 20 has been removed from the surface of the first portion 112.

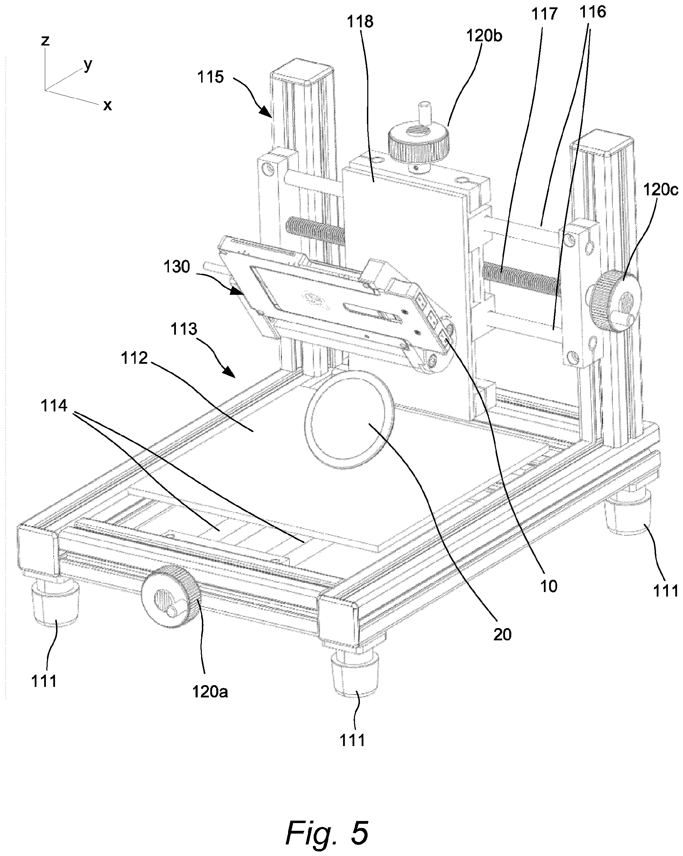

In one alternative embodiment, as seen in Figs. 5-6, the wireless power transmitter device 20 has an inclined surface, where the inclination is in relation to the extension of the first portion 112. The wireless power transmitter device 20 may be arranged in a holding means, as previously described, or directly on the first portion 112. The surface of the wireless power transmitter device 20 resembles charging the wireless power receiver device 10 on an inclined surface. This may be the case with a wireless power transmitter device 20 having a tilted surface. A charger with a tilted surface allows the user to look at the screen of the device once the devices is charged in the charger.

### The wireless power receiver device

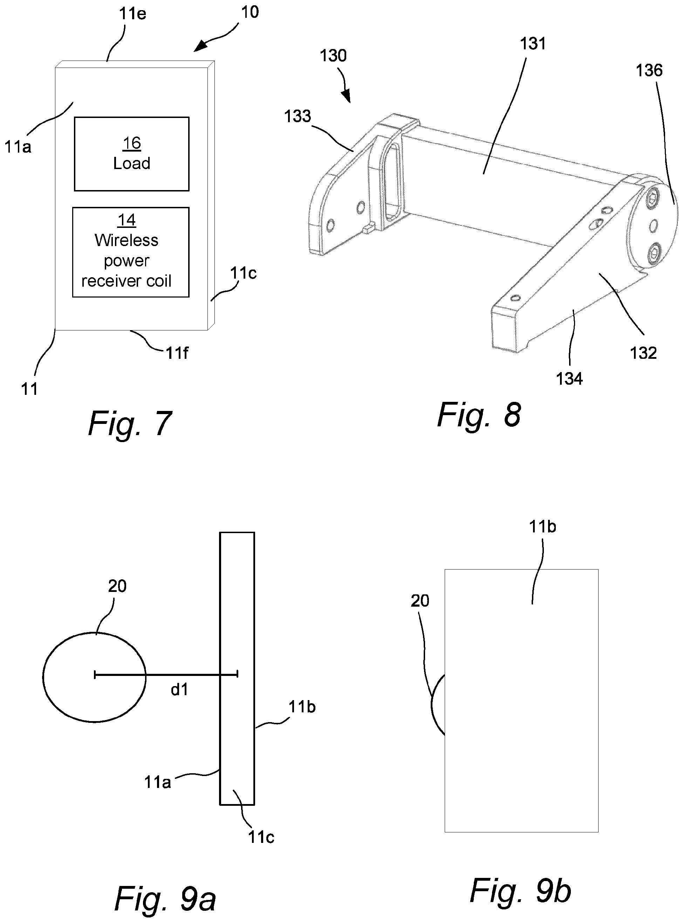

The wireless power receiver device 10 is schematically illustrated in Fig. 7. The wireless power receiver device 10 comprises at least one load 16 and at least one wireless power receiver coil 14. In this illustrative example, the wireless power receiver device 10 has essentially the shape of a thin box with rounded edges and corners. In one embodiment the wireless power receiver device 10 is a testing device that for example emulates a mobile device. In an alternative embodiment, the wireless power receiver device 10 is an end user device, such as a consumer device, that has a testing mode. Hence, the wireless power receiver device 10 could be a mobile device such as for instance, a mobile terminal (e.g. smartphone), tablet computer (e.g. surfpad), laptop computer or another kind of consumer product or appliance being configured with a testing mode.

The wireless power receiver device 10 has a housing 11 having a bottom side 11a adapted for placement on a surface of the wireless power transmitter device 20. Moreover, the housing comprises a front surface 11b (shown in Fig. 9a) being arranged opposite to the bottom surface. The housing 11 further has two side surfaces 11c being arranged between the bottom surface 11a and the front surface 11b, and opposite each other. Additionally, the housing 11 comprises a top side surface 11e and a bottom side surface 11f, being arranged opposite each other. The two side surfaces 11c have a length that is longer than the top side surface 11e and the bottom side surface 11f, so as to get the substantially rectangular shape.

### Main body

As seen in Figs. 2-6, the first portion 112 is arranged in a first sub-structure 113. The first sub-structure 113 may be seen as a frame-like structure. The frame-like structure 113 may have a rectangular shape or any other form. The first portion 112 is arranged in the frame-like structure 113. The first portion 112 is preferably movably arranged in the sub-structure 113.

The movement of the first portion 112 may be realized by connecting means 114 that allows the first portion 112 to move in the sub-structure 113. In one embodiment the connecting means 114 are realized as a plurality of connecting rods. However, it should be realized that the first portion 112 could be movably arranged in other ways as well. In the specific embodiments of Figs. 2-6, each connecting means 114 comprises three rods that extends in the movement direction of the first portion 112. The movement of the first portion 112 is controlled using position adjustment means 120a-c, which soon will be described more in detail.

The main body 110 may further comprise a plurality of feet 111. In the embodiments shown in Figs. 2-6, four feet are arranged on the bottom side of the frame-like structure 113. The feet 111 are preferably arranged on the side of the frame-structure 113 that is to be placed on a surface such as a table, being opposite the side that is arranged with the first portion 112. Although four feet 111 are illustrated, any number of feet that provides sufficient support to the system 100 may be possible.

In the embodiments shown in Figs. 2-6, the second portion 118 can be seen as being in the shape of a plate extending along the z-x-direction. In one embodiment, the second portion 118 is movable at least along the vertical axis, being the z-axis in Figs. 2-6.

The second portion 118 is arranged in a second sub-structure 115. The second sub-structure 115 comprises a plurality of connecting means 116 that allows the second portion 118 to move. In the embodiments shown in Figs. 2-6, the connecting means 116 are realized as a plurality of connecting rods. However, it should be realized that the second portion 118 could be movably arranged in other ways as well. In the specific embodiments of Figs. 2-6, each connecting means 116 comprises two rods that extends in the movement direction of the second portion 118.

The second portion 118 comprises an attachment member 130. The attachment member 130 preferably extends out from the second portion 118, for example in the x-y-plane. The attachment member 130 is arranged to receive a wireless power receiver device 10. The wireless power receiver device 10 is preferably removably attached to the attachment member 130 so as to allow testing of different devices 10.

The attachment member 130 for holding the wireless power receiver device 10 is shown in more detail in Fig. 8. The attachment member 130 shown in Fig. 8 is adapted to accommodate a wireless power receiver device 10 having the shape similar to that described in relation to Fig. 7. As would be understood by a person skilled in the art, the shape and dimensions of the attachment member 130 will reflect the shape of the wireless power receiver device 10 that it is configured to hold.

In the embodiment shown in Fig. 8, the attachment member 130 comprises a back portion 131 and two side portions 132, 133. Once the wireless power receiver device 10 is accommodated therein, the top side surface 11e is facing one of the side portions 132, 133 and the bottom side surface 11f is facing the other side portions 132, 133. One of the side surfaces 11c are arranged facing the back portion 131.

At least one of the side portions 132 comprises gripping means 134. The gripping means 134 may for example be a recess arranged to receive the width of the wireless power receiver device 10. Additionally or alternatively, the gripping means 134 is the clamping force created when the device 10 is placed in the attachment member 130.

The attachment member 130 further comprises rotating means 136. The rotating means 136 are arranged to move, or rotate, the wireless power receiver device 10 arranged therein. In this way, different positions of the wireless power receiver device 10 can be achieved so as to allow for testing the behavior of the wireless power receiver device 10 and/or the wireless power transmitter device 20 at different orientations. The rotation serves two purposes, i.e. a) to facilitate testing a wireless power transmitter device 20 that has a titled charging surface, and b) to provide an easy and controlled method to move the wireless power receiver device 10 into the operating area of the wireless power transmitter device 20. As an example, a lever could be connected to the rotating means 136 to facilitate moving the power receiver device 10 into testing position in a controlled manner. The rotating means 136 can comprise specific settings that limit or restrict the movement of rotation for the purpose of repeatability or consistency as well as to adapt the positioning system to variations on both the power receiver device 10 as well as the power transmitter device 20.

The attachment member 130 further comprises restriction means configured to restrict the rotation of the attachment member.

The attachment member 130 can be arranged in different positions, so as to allow different measurement positions of the wireless power receiver device 10. The attachment member 130 can be moved between a first and a second end positions and a plurality of positions there between. In one embodiment the movable attachment member 130 is arranged to be rotatable around its back portion 131. The back portions 131 substantially parallel to the x-axis. The rotation could also be seen as a movement in the zy-plane. The embodiment shown in Figs. 2-3 and the embodiment shown in Figs. 5-6 will now be discussed together.

In Figs. 2 and 5, the attachment member 130 is arranged in a first end position. In the first end position the attachment member 130 is arranged such that the wireless power receiver device 10 being arranged therein is arranged at a distance from the wireless power transmitter device 20 of the first portion 112. In this example, the wireless power receiver device 10 and the wireless power transmitter device 20 is arranged with an angular offset of approximately 90 degrees, so as to minimize any electromagnetic coupling between the two devices.

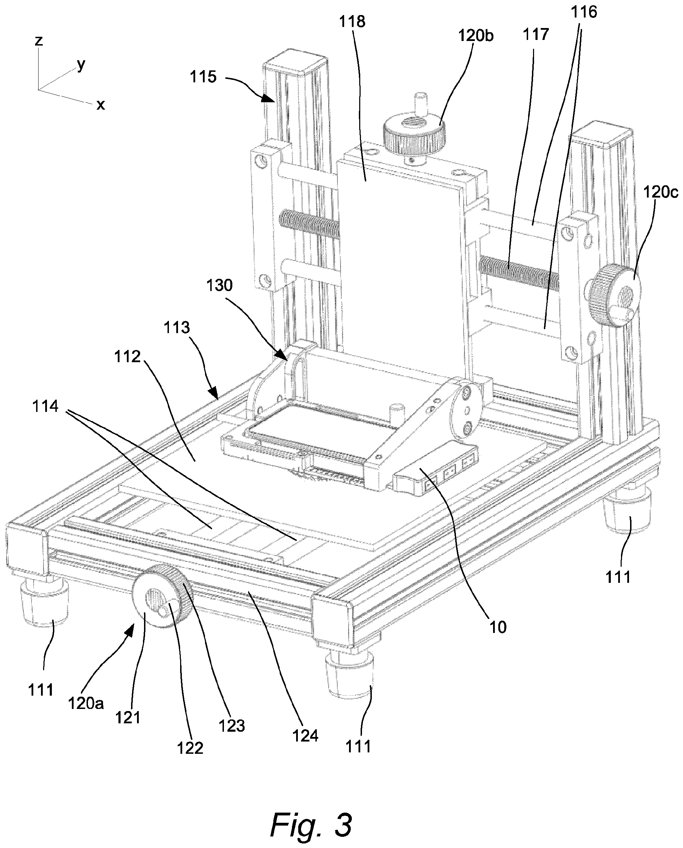

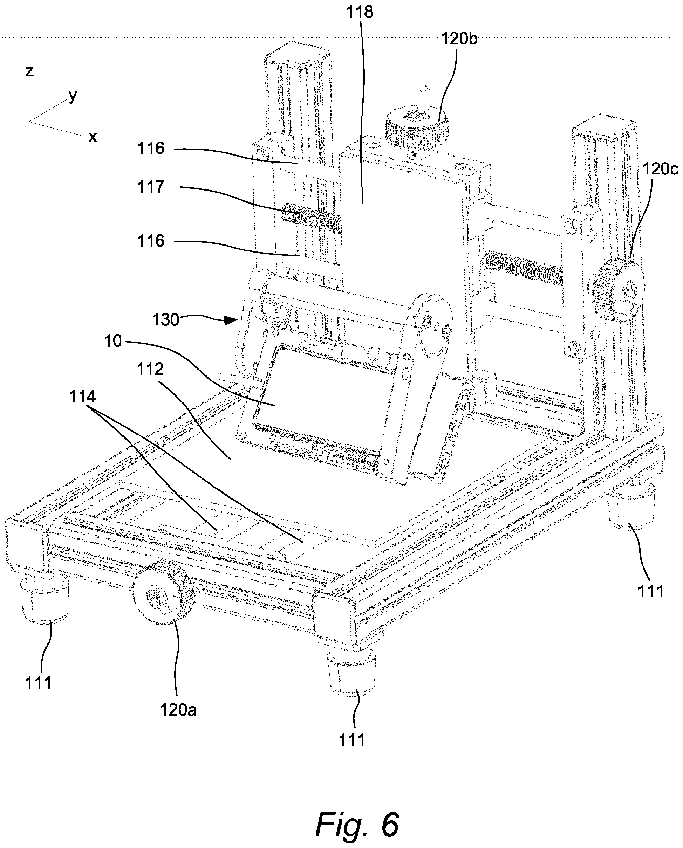

In Figs. 3 and 6, the attachment member 130 is arranged in a second end position. In the second end position, the attachment member 130 is arranged such that the wireless power receiver device 10 being arranged therein is arranged adjacent to the wireless power transmitter device 20 of the first portion 112. Hence, there is no distance between the wireless power receiver device 10 and the wireless power transmitter device 20, and the wireless power receiver device 10 can be seen as lying on top of the wireless power transmitter device 20.

The first and second end positions achieved by the attachment member 130 are further illustrated in Figs. 9a-b. Typically, the rotating means 136 from Fig 8 is used to transition from the first to the second end position. In Fig. 9a, a top view is shown illustrating the location of the wireless power receiver device 10 in relation to the wireless power transmitter device 20 when the attachment member 130 is arranged in a first end position. Depending on the position of the first portion 112, the distance d1 between the center point of the wireless power transmitter device 20 and the center point of the wireless power receiver device 10 may vary. Here the bottom side 11a of the housing 11 is facing the side of the wireless power transmitter device 20. The side surface 11c of the housing 11 is facing up in the same direction as the wireless power transmitter device 20 is facing.

In Fig. 9b, a top view is shown illustrating the location of the wireless power receiver device 10 in relation to the wireless power transmitter device 20 when the attachment member 130 is arranged in a second end position. Depending on the position of the first portion 112, the distance between the center point of the wireless power transmitter device 20 and the center point of the wireless power receiver device 10 may vary. Here the bottom side 11a of the housing 11 is facing the top surface of the wireless power transmitter device 20.

Turning back to Figs. 2-6, the position adjustment means 120a-c will now be described more in detail. The movement of the first portion 112, the second portion 118 and/or the attachment member 130 is controlled using position adjustment means 120a-c. The position adjustment means 120a-c is such that it allows for accurate small movements of the first portion 112, the second portion 118 and/or the attachment member 130. The position adjustment means 120a-c may be purely mechanical, purely electronic or a mixture of both.

In one embodiment, as shown in Figs. 2-6, the position adjustment means 120a-c comprises a positioning wheel 121 having a plurality of small teeth 123. The teeth 123 of the positioning wheel 121 is preferably arranged along the whole circumference of the wheel 121, such that an external drive mechanism could be used to adjust the positioning. This drive mechanism could be automated or manually controlled. The wheel 121 may be seen as a circular gear (such as a pinion). The positioning wheel 121 preferably has a knob 122 so as to allow the user to adjust the position in small incremental steps.

The position adjustment means 120c is arranged to adjust the movement of the second portion 118. By rotating the positioning wheel 120c, a spindle 117 will start to rotate. The rotation of the spindle 117 moves the second portion 118 along the axis of the spindle 117.

The first portion 112 is controlled in a similar manner, using a positioning wheel 120a which cases a rotation of the spindle 124, which in turn causes a movement of the first portion 112.

The use of a spindle is also true for the movement of the attachment member 130.

In an alternative embodiment (not shown) the positioning wheel is arranged to a toothed bar or rod i which the positioning wheel is arranged. The toothed bar arranged on one of the sides of the frame-like structure 113.

The positioning wheel is connected to the connecting means 114 in a way so as to provide movement of the first portion 112 by altering the position of the positioning wheel 121.

Figs. 10a-b shows two alternative embodiments of a positioning system, showing schematic top views of the first portion 112 being arranged in a frame-like structure 113.

In addition to the changes of position described this far, the positioning system could also be equipped with means to achieve changes in orientation through rotation. This can be achieved by rotating the portion 112 around its axis in the same plane as the portion 112, and similarly rotate the portion 118 around its axis in the same plane as portion 118. Including these rotations would result in the positioning system 100 being able to move the wireless power devices 10 and 20 across all 6 degrees of freedom relative to each other.

In Fig. 10a, the first portion 112 is configured to be movable in both directions of the plane, i.e. both along the x-axis and the y-axis. In this embodiment, the first sub-structure 113 comprises two position adjustment means 120a-b. Here, the first position adjustment means 120a is arranged to control the movement along the y-axis and the second position adjustment means 120b is arranged to control the movement along the x-axis. The position adjustment means are described further in relation to Figs. 9a-b.

In this embodiment one wireless power transmitter device 20, having one power transmitter coil 24, is arranged on the first portion 112. In this embodiment, the power transmitter coil 24 of the wireless power transmitter device 20 is illustrated as having the shape of a circle, although it should be understood that the wireless power transmitter device 20 could have any suitable shape such as a square, hexagon and the like.

Fig. 10b shows an embodiment where the first portion 112 is configured to be movable in only one directions of the plane, i.e. only along the y-axis. In this embodiment, the first sub-structure 113 comprises one position adjustment means 120a. Here, the position adjustment means 120a is arranged to control the movement along the y-axis.

In this embodiment one wireless power transmitter device 20, comprising four power transmitter coils 24(a-d), are arranged on the first portion 112. In this embodiment, the wireless power transmitter device 20 is illustrated as having the shape of a square, although it should be understood that the wireless power transmitter device 20 could have any suitable shape. Moreover, in this illustration, four wireless power transmitter coils 24a-d are disclosed on the first portion 112, however any reasonable number of wireless power transmitter coils 24 could be used. Additionally, any reasonable number of wireless power transmitter devices 20 could be arranged on the first portion 112.

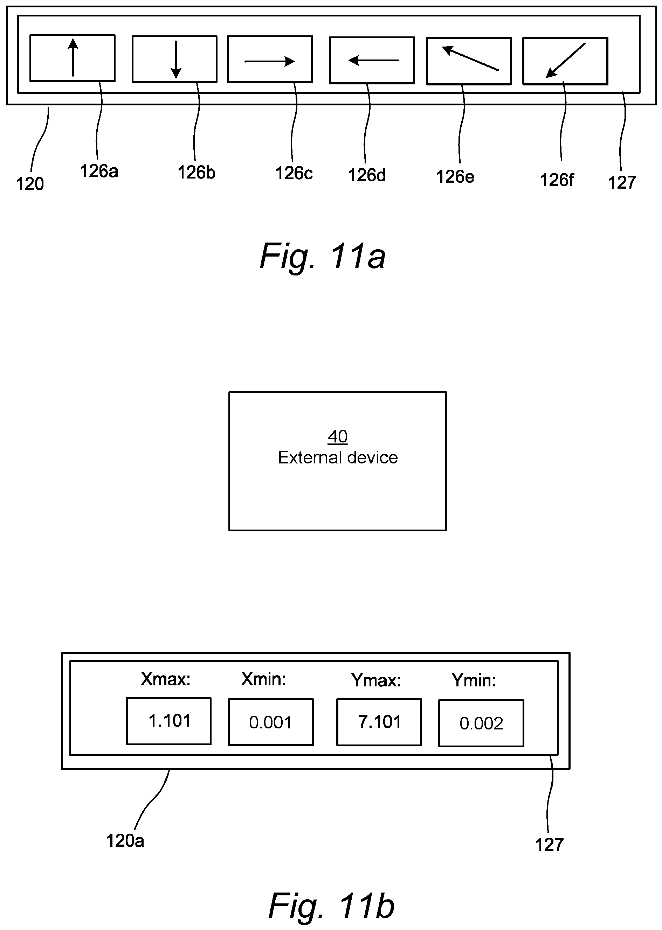

Figs. 11a-b illustrates alternative embodiment of the adjustment means 120. In Fig. 11a, the adjustment means 120 in this illustrative embodiment comprises digital adjustment means. The adjustment means 120 may comprise a display 127, such as for example touch sensitive display. The display 127 may be configured to display graphical objects 126a-f that are selectable by a user to modify the position of the different parts of the system 100. Additionally, or alternatively, the adjustment means 120 may comprise one or more physical buttons. These buttons may be used to adjust the position of the different parts of the system 100.

Fig. 11b shows an illustrative embodiment of an adjustment means 120. In this embodiment, the control of the positioning system 100 is performed remotely, i.e. in another device. Hence, the adjustment means 120 in this illustrative embodiment is in communicative connection with an external device 40. The external device 40 may for example be a laptop computer, a personal computer, a work station, etc., or another kind of computer or computing device.

Additionally or alternatively to having an external device 40, the system 100 may be in operative communication with a processing unit. The processing unit may be arranged within the positioning system 100 or be part of a connected testing system. The processing unit may be configured to process the testing data generated by the positioning system 100. The processing unit may be configured to provide feedback to the user of the positioning system 100. The feedback may relate to how parts of the positioning system 100, such as for example the first portion 112 with the wireless power transmitter device 20, needs to be re-positioned. If a holding means for the wireless power transmitter device 20 is present, the inclination of the holding means may additionally need re-positioning.

In one embodiment the feedback is transmitted to an external device of the user. The user may then manually, using the adjustment means 120 of the positioning system, alter the position of the different components of the system 100. Additionally, or alternatively, in one embodiment the feedback is transmitted back to the positioning system 100 itself so that it automatically may adjust the position of the components needed re-positioning.

In the field of wireless power testing it is important that the positioning system uses a minimum (or none) electrically conducting or magnetically active materials (such as metal, ferrites, magnets, iron, etc) as this can impact the behavior of the device being tested.

The positioning system 100 described herein is at least in part constructed by a materials that do not interfere with the wireless power transfer; i.e. materials that have high electrical resistivity and a relative permeability (µ_{R}) very close to the value 1.0. One example of such material may comprise thermosetting polymers or thermoplastics. In one embodiment the main body 110 is constructed by fiberglass (i.e. a fiber-reinforced plastic using glass fiber), Polyether Ether Ketone (PEEK), Polyoxymethylene (POM), or similar. The material may for example also be made of glass, wood or other non-magnetic material. The same material choices may be applied to other parts of the positioning system 100, such as the first and second portions 112, 118, position adjustment means 120a-c, attachment member 130, and/or the connecting means 114, 116.

The main body 110, the first and second portions 112, 118, position adjustment means 120a-c, attachment member 130, and/or the connecting means 114, 116 may be produced by injection molding.

At least some parts of the housing are made of plastic or another material suitable for admitting inductive coupling between the wireless power transmitter coil(s) 24 of the wireless power transmitter device 20 and the wireless power receiver coil(s) 14 of the wireless power receiver device 10.

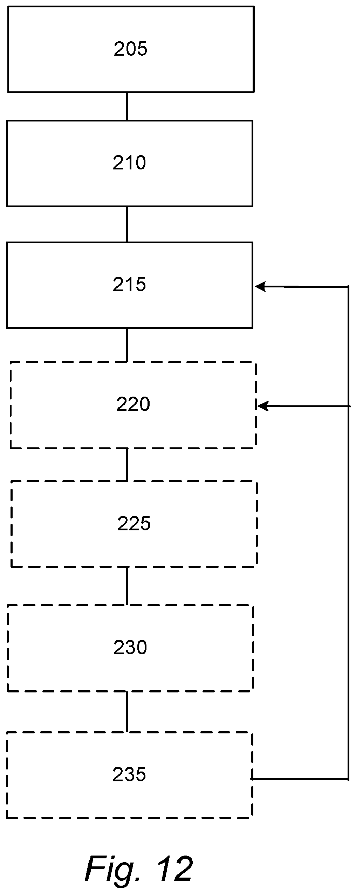

Fig. 12 illustrates a method for positioning a wireless power transmitter device and/or a wireless power receiver device for testing of wireless power equipment. The method comprises a step of providing 205 a first portion 112 arranged to receive at least one wireless power transmitter device 20. It further comprises a step of providing 210 a second portion 118 comprising a movable attachment member 130 arranged to receive one wireless power receiver device 10. The method further comprises controlling 215 or causing a rotation of the attachment member 130 between a first end position and a second end position. The method may further comprise controlling 220 or causing a movement of the first portion 112 and/or the second portion 118.

The method may further comprise controlling or adjusting 225 the holding means between a flat and an inclined position.

The method may further comprise providing 230 feedback of the positioning system 100 relating to re-positioning of the first portion 112, the second portion 118 and/or the attachment member 130.

In one embodiment the method further comprises causing re-positioning 235 of the first portion 112, the second portion 118 and/or the attachment member 130 based on feedback of the positioning system 100

The invention has been described above in detail with reference to embodiments thereof. However, as is readily understood by those skilled in the art, other embodiments are equally possible within the scope of the present invention, as defined by the appended claims.

## Claims

1. A positioning system (100) for testing of wireless power equipment in the form of a wireless power transmitter device (20) and/or a wireless power receiver device (10), the positioning system (100) comprising a main body (110) comprising:
a first portion (112) arranged to receive at least one wireless power transmitter device (20),
a second portion (118) comprising a movable attachment member (130) arranged to receive one wireless power receiver device (10), wherein the attachment member (130) comprises rotating means (136) configured to provide a rotation of the movable attachment member (130), and
at least one position adjusting means (120) arranged to control the rotation of the attachment member (130) between a first end position and a second end position.

2. The positioning system (100) as defined in claim 1, wherein the rotating means (136) comprises restriction means configured to restrict the rotation of the attachment member.

3. The positioning system (100) as defined in claim 1 or 2, wherein the first portion (112) is arranged to be movable along the y-axis, and wherein the second portion (118) is arranged to be movable along the x-axis.

4. The positioning system (100) as defined in any preceding claims, wherein the movable attachment member (130) is arranged to be rotatable around its axis.

5. The positioning system (100) as defined in any preceding claims, wherein in the first end position the attachment member (130) is arranged such that the wireless power receiver device (10) is arranged at distance from the wireless power transmitter device (20).

6. The positioning system (100) as defined in any preceding claims, wherein in the second end position the attachment member (130) is arranged such that the wireless power receiver device (10) is arranged adjacent to the wireless power transmitter device (20).

7. The positioning system (100) as defined in any preceding claim, wherein the at least one wireless power transmitter device (20) is arranged on a holding means, wherein the holding means is configured to be adjustable between a flat and an inclined position.

8. The positioning system (100) as defined in any preceding claim, wherein the first portion (112), the second portion (118) and/or the movable attachment member (130) is made of a non-magnetic material.

9. The positioning system (100) as defined in any preceding claim, wherein the positioning system (100) is in operative communication with a processing unit.

10. The positioning system (100) as defined in claim 9, wherein the processing unit is configured to provide feedback to the user of the positioning system (100) relating to re-positioning of the first portion (112), the second portion (118) and/or the attachment member (130).

11. The positioning system (100) as defined in claim 9 or 10, wherein the processing unit is configured to provide feedback to the positioning system (100) and to instruct re-positioning of the first movable portion (112), the second movable portion (118) and/or the attachment member (130).

12. The positioning system (100) as defined in claim 10 or 11, wherein the feedback is generated based on test data.

13. The testing device as defined in any preceding claim, wherein the wireless power transmitter device (20) is in the form of a wireless charger (20).

14. A method for positioning a wireless power transmitter device (20) and/or a wireless power receiver device (10) for testing of wireless power equipment, the method comprising:
providing (205) a first portion (112) arranged to receive at least one wireless power transmitter device (20),
providing (210) a second portion (118) comprising a movable attachment member (130) arranged to receive one wireless power receiver device (10), wherein the attachment member (130) comprises rotating means (136) configured to provide a rotation of the movable attachment member (130), and
controlling (215) the rotation of the attachment member (130) between a first end position and a second end position.
